# EUROPEAN PATENT SPECIFICATION

(11) **EP 1 243 411 B1**
(45) Date of publication and mention of the grant of the patent: **02.01.2004**
(21) Application number: 01000065.1
(22) Date of filing: 22.03.2001
(51) Int. Cl.: B41C 1/10, B41J 2/01, B41N 3/00, G03F 7/16

(54) **Method of coating an image-recording layer by ink-jet**
Tintenstrahlbeschichtungsverfahren für eine Bildaufzeichnungsschicht
Méthode pour revêtir une couche pour l'enregistrement d'images par jet d'encre

(43) Date of publication of application: 25.09.2002
(73) Proprietor: AGFA-GEVAERT, 2640 Mortsel (BE)
(72) Inventor: Verschueren, Eric, 2640, Mortsel (BE)

(56) References cited:
- WO-A-94/11191
- WO-A-99/48696
- WO-A-99/59826
- DE-A- 3 911 934
- DE-A- 4 339 493
- US-A- 5 713 287
- US-A- 5 871 879

## Description

### FIELD OF THE INVENTION

The present invention relates to a method for making a printing plate precursor by applying an image-recording layer on a substrate by means of a valve-jet print head. The method is preferably used for on-press coating, i.e. while the substrate is mounted in a printing press.

### BACKGROUND OF THE INVENTION

Lithography is the process of printing from specially prepared surfaces, some areas of which are capable of accepting lithographic ink, whereas other areas, when moistened with water, will not accept the ink. The areas, which accept ink, form the printing image areas and the ink-rejecting areas form the background areas.

In the art of photolithography, a photographic material is made image-wise receptive to oily or greasy ink in the photo-exposed (negative working) or in the non-exposed areas (positive working) on a hydrophilic background.

In the production of common lithographic plates, also called surface litho plates or planographic printing plates, a support that has affinity to water or obtains such affinity by chemical treatment is coated with a thin layer of a photosensitive composition. Coatings for that purpose include light-sensitive polymer layers containing diazo compounds, dichromate-sensitised hydrophilic colloids and a large variety of synthetic photopolymers. Particularly diazo-sensitised systems are widely used. Upon image-wise exposure of the light-sensitive layer the exposed image areas become insoluble and the unexposed areas remain soluble. The plate is then developed with a suitable liquid to remove the diazonium salt or diazo resin in the unexposed areas.

So-called direct-to-plate methods involve the direct exposure of a printing plate precursor with image data, contrary to the conventional plate-making methods wherein a film mask is used for contact exposure of the plate precursor. In such direct-to-plate methods imaging elements are often used that are heat-sensitive rather than photosensitive. Heat-sensitive imaging elements having an image forming layer comprising hydrophobic thermoplastic polymer particles dispersed in a water or alkali soluble or swellable resin and a compound capable of converting light into heat, are disclosed in e.g. EP-A- 770 494, EP-A- 770 495, EP-A- 770 496, EP-A- 770 497, EP-A- 773 112, EP-A- 773 113, EP-A- 774 364, EP-A- 800 928, EP-A- 96 202 685, EP-A- 96 203 003, EP-A- 96 203 004 and EP-A- 96 203 633. In most cases carbon black or an IR-dye are mentioned as the compound capable of converting light into heat.

The coatings which are used for the preparation of lithographic printing plate precursors are normally applied with industrial coating techniques such as dip-coating, cascade coating and curtain coating. On the other hand, so-called on-press coating techniques are known, whereby one or more coatings are applied on a lithographic substrate on-press, i.e. while the lithographic substrate is mounted in a printing press, as described in e.g. in GB1546532, EP-A 101 266 and US 5,713,287. Such methods normally also involve on-press imaging by means of an image-setter that is integrated in the press. The on-press coating is typically achieved by means of a spray device, as disclosed in e.g. US 4,626,484, EP-A-818 711 and US 5,713,287.

Several spraying techniques are known in the art : the air-assisted spraying method comprises using a compressed air as propellant; the airless spraying method (liquid pressure spraying method) comprises spraying the coating solution by applying high pressure to the coating solution. The electrostatic spraying method comprises spraying the coating solution by electrostatic force. These spraying methods produce low quality coatings, characterized by the presence of lines or a mottle pattern in the coated layer. Another disadvantage of spraying methods is the low yield since up to 50% of the atomised coating solution may be wasted into the environment. Furthermore there is a high risk of contaminating printing press hardware elements such as ink rollers, imaging units, cleaning units.

The above disadvantages can be solved by using a jet technique instead of spraying. Suitable jet techniques for on-press coating have been described in European patent application no. EP-A-1 179 422 filed on 31.07.2000. The jet techniques mentioned therein are continuous ink-jet and drop-on-demand ink-jet, used for applying a homogeneous coating on a lithographic substrate, i.e. the coating is not applied image-wise. A problem of the mentioned jet and spray techniques is the limited thickness of the coating that is applied by a single pass of the print head. In addition, the mentioned jet techniques require a careful adjustment of the physico-chemical properties of the coating solution, e.g. electroconductivity, viscosity, and surface tension and such adjustments may be incompatible with the requirements necessary for obtaining a high lithographic quality such as contrast, sharpness and printing endurance (run length).

### SUMMARY OF THE INVENTION

It is an object of the present invention to provide a method for applying an image-recording layer on a substrate which enables to obtain a sufficiently thick coating rapidly and which is compatible with most image-recording compositions known in the art of lithographic printing. This object is realised by the method of claim 1. The printing plate precursor obtained by this method can be exposed and optionally processed so as to obtain a printing master comprising a lithographic image.

In another embodiment of the present invention, the coating is removed from the substrate in a cleaning step, carried out after finishing the print job, so that the substrate is recycled and can be reused in a next cycle of coating, exposing and printing. All the steps of coating, exposing and cleaning are preferably carried out on-press, i.e. while the substrate is mounted in a printing press.

Preferred embodiments of the methods of the present invention are defined in the dependent claims. Further advantages and preferred embodiments of the present invention will become apparent from the description hereinafter.

### BRIEF DESCRIPTION OF THE DRAWINGS

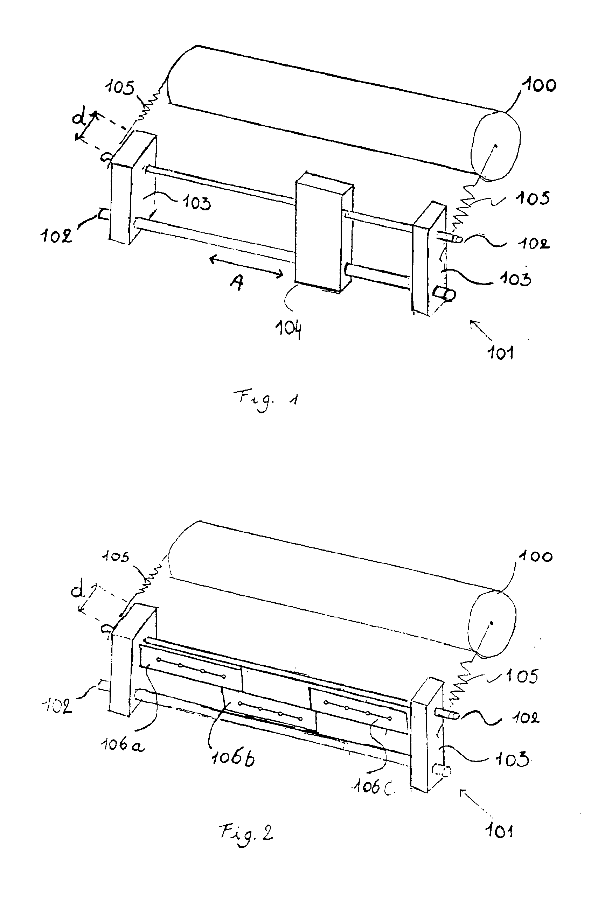

Figures 1 and 2 each show a schematic representation of a preferred system for use in the methods of the present invention, comprising a valve-jet print head in the vicinity of a press cylinder.

### DETAILED DESCRIPTION OF THE INVENTION

According to the methods of the present invention, a heat- or light-sensitive image-recording layer is applied on a lithographic substrate by means of a valve-jet print head, thereby obtaining a printing plate precursor. Valve-jetting is a type of drop-on-demand jet technique that typically uses a solenoid to open and shut a valve. The coating solution behind the valve is under pressure and as the valve is opened, a drop of the solution is shot from the valve and travels to the substrate. The drop frequency is typically in the range from 2 to 4 Khz, although not limited tot this range. In a preferred embodiment, pressurised gas is used for driving the coating solution out of the valve-jet print head. Valve-jet print heads are known in the art and commercially available, e.g. from Matthews Swedot AB in Sweden.

The coating solution is normally applied on the substrate to form a continuous layer. The substrate can be mounted on a rotatable drum and the print head can be mounted on a shuttle which travels near the substrate along the axial direction of the drum, as shown in Figure 1. In the embodiment wherein the substrate is not a seamless sleeve, the edges of the substrate can be fixed to the drum by the known means, e.g. clamps which are typically used for fixing a printing plate to a print cylinder. Such clamps normally define a non-printing gap. In said gap, no substrate is available for being coated by the print head. During the coating operation, the valve-jet print head can be switched off each time the gap passes the print head so that the coating solution is only applied on the substrate and not on the gap.

The embodiment of figure 1 will now be discussed in more detail. The press cylinder (100) carries a lithographic substrate (not shown) on its outer surface. On a frame (101) with bars (102) and supporting means (103) a shuttle with an valve-jet print head is mounted in such a way that it can be moved back and forth in the direction of arrow A. The supporting means (103) of the frame serve in this embodiment also as spacers for keeping the frame at a constant distance (d) from the cylinder (100). The supporting means (103) are brought in contact with the outermost edges of the cylinder and kept there by resilient means such as spring coils (105).

An alternative system is shown in Figure 2. A plurality of valve-jet print heads is mounted in a staggered configuration, so that the sum of the printing width of each separate print head equals the useful width of the lithographic substrate. In this embodiment, the ink-jet print heads are fixed and do not have to move back and forth over the width of the lithographic substrate. In figure 2, all numerals are the same as in figure 1, but the shuttle (104) is replaced by three staggered print heads (106a, 106b and 106c) which each comprise a plurality of valve-jet orifices (only four shown in the Figure). Other suitable configurations of staggered print heads have been disclosed in, e.g., US-A-4 922 271, US-A 940 998 and US-A-5 428 375. A combination of a shuttle which carries a plurality of staggered print heads is also a possible implementation for an arrangement to implement the method of this invention.

### The substrate

The substrate used in the methods of the present invention may have any affinity for ink and/or an ink-abhesive fluid such as fountain solution (also called dampening liquid). A driographic printing plate precursor can be obtained by providing an ink-abhesive substrate with an ink-accepting image-recording layer, or an image-recording layer which becomes ink-accepting after exposure, and optional processing. Alternatively, a driographic material can also be obtained by providing an ink-accepting substrate with an ink-abhesive image-recording layer, or an image-recording layer which becomes ink-abhesive after exposure, and optional processing. A conventional lithographic material can be obtained by providing a hydrophilic substrate with a hydrophobic image-recording layer, or an image-recording layer which becomes hydrophobic after exposure and optional processing. Alternatively, a conventional (wet offset) lithographic material can also be obtained by providing a hydrophobic substrate with a hydrophilic image-recording layer, or an image-recording layer which becomes hydrophilic after exposure and optional processing.

According to still another embodiment, the affinity of the substrate for ink or for an ink-abhesive fluid is irrelevant, more particularly when the substrate is coated with a so-called switchable image-recording layer, because such a layer can be image-wise converted from a hydrophobic state to a hydrophilic state or vice-versa and a lithographic image is thus obtained immediately after exposure without the need of removing the layer for obtaining the opposite affinity towards ink or fountain.

The substrate used in the methods of the present invention may be a sheet-like material such as a plate or it may be a cylindrical element such as a sleeve which can be slid around a print cylinder of a printing press. Alternatively, the substrate can also be the print cylinder itself. The lithographic substrate is preferably a hydrophilic support or a support which is provided with a hydrophilic layer. Preferably, the support is a metal support such as aluminum or stainless steel.

A particularly preferred substrate is an electrochemically grained and anodized aluminum support. The anodized aluminum support may be treated to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde It is further evident that one or more of these post treatments may be carried out alone or in combination. More detailed descriptions of these treatments are given in GB-A- 1 084 070, DE-A- 4 423 140, DE-A- 4 417 907, EP-A- 659 909, EP-A- 537 633, DE-A- 4 001 466, EP-A- 292 801, EP-A- 291 760 and US-P- 4 458 005.

According to another embodiment, the substrate can also be a flexible support, which is provided with a hydrophilic layer, hereinafter called 'base layer'. The flexible support is e.g. paper, plastic film or thin aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm.

The hydrophilic binder for use in the base layer is e.g. a hydrophilic (co)polymer such as homopolymers and copolymers of vinyl alcohol, acrylamide, methylol acrylamide, methylol methacrylamide, acrylate acid, methacrylate acid, hydroxyethyl acrylate, hydroxyethyl methacrylate or maleic anhydride/vinylmethylether copolymers. The hydrophilicity of the (co)polymer or (co)polymer mixture used is preferably the same as or higher than the hydrophilicity of polyvinyl acetate hydrolyzed to at least an extent of 60% by weight, preferably 80% by weight.

The amount of hardening agent, in particular tetra-alkyl orthosilicate, is preferably at least 0.2 parts per part by weight of hydrophilic binder, more preferably between 0.5 and 5 parts by weight, most preferably between 1 parts and 3 parts by weight.

The hydrophilic base layer may also contain substances that increase the mechanical strength and the porosity of the layer. For this purpose colloidal silica may be used. The colloidal silica employed may be in the form of any commercially available water dispersion of colloidal silica for example having an average particle size up to 40 nm, e.g. 20 nm. In addition inert particles of larger size than the colloidal silica may be added e.g. silica prepared according to Stöber as described in J. Colloid and Interface Sci., Vol. 26, 1968, pages 62 to 69 or alumina particles or particles having an average diameter of at least 100 nm which are particles of titanium dioxide or other heavy metal oxides. By incorporating these particles the surface of the hydrophilic base layer is given a uniform rough texture consisting of microscopic hills and valleys, which serve as storage places for water in background areas.

Particular examples of suitable hydrophilic base layers for use in accordance with the present invention are disclosed in EP-A- 601 240, GB-P- 1 419 512, FR-P- 2 300 354, US-P- 3 971 660, and US-P- 4 284 705.

It is particularly preferred to use a film support to which an adhesion improving layer, also called substrate layer, has been provided. Particularly suitable adhesion improving layers for use in accordance with the present invention comprise a hydrophilic binder and colloidal silica as disclosed in EP-A- 619 524, EP-A- 620 502 and EP-A- 619 525. Preferably, the amount of silica in the adhesion improving layer is between 200 mg/m² and 750 mg/m². Further, the ratio of silica to hydrophilic binder is preferably more than 1 and the surface area of the colloidal silica is preferably at least 300 m²/gram, more preferably at least 500 m²/gram.

### The image-recording layer

The printing plate precursor is an imaging material which comprises at least one image-recording layer provided on the lithographic substrate. Preferably, only a single layer is provided on the substrate. The material may be light- or heat-sensitive, the latter being preferred because of daylight-stability. In principle, any known direct-to-plate technology is suitable, especially in the embodiment using an off-press exposure apparatus. Known materials are e.g. light-sensitive plates such as photopolymer plates and silver diffusion transfer plates, or heat-sensitive (so-called thermal) plates which rely on e.g. heat-induced solubilization of a polymer layer or heat-induced release of an acid which triggers cross-linking of a polymer layer (insolubilization).

Highly preferred imaging materials for use in the present invention have an image-recording layer which does not require any processing so that a printing master is obtained immediately after exposure. This is especially advantageous in the embodiment using on-press exposure. Processless materials can be based on various mechanisms. Ablative plates typically use layers which may be removed by high-energy infrared laser exposure, e.g. metal layers, or thermally unstable layers which may contain self-oxidizing polymers such as nitrocellulose. Typical ablative materials are disclosed in EP 628 409; WO98/55330; US 5,401,611; DE 19 748 711; US 5,605,780; US 5,691,114, WO97/00735; US 4,054,094 and EP 882 582. Non-ablative processless plates comprise e.g. switchable polymers (e.g. EP 924 102) which can be image-wise converted from a hydrophobic state to a hydrophilic state (WO92/09934; EP 652 483) or vice-versa (US 4,081,572; EP 200,488, EP 924 065). Other examples of processless plates are based on the thermally induced rupture of microcapsules and the subsequent reaction of the microencapsulated oleophilic materials (isocyanates) with functional (hydroxyl-)groups on cross-linked hydrophilic binders (US 5,569,573; EP 646 476; WO94/2395; WO98/29258).

In another highly preferred embodiment, the imaging material may be processed on-press by the liquids which are used during printing (so-called 'hidden processing'), e.g. by supplying ink and/or fountain solution to the image-recording layer. In that embodiment, the image-recording layer is removable with the ink and/or fountain or can be rendered removable therewith upon exposure to heat or light. Instead of ink and fountain, on-press processing and subsequent printing can also be done with so-called single-fluid ink. Single-fluid inks which are suitable for use in the method of the present invention have been described in US 4,045,232 and US 4,981,517. In a most preferred embodiment, the single fluid ink comprises an ink phase, also called the hydrophobic or oleophilic phase, and a polyol phase as described in WO 00/32705.

Preferred 'hidden processing' imaging materials comprise a hydrophilic substrate. They can be positive-working, i.e. the exposed areas of the image-recording layer are rendered removable with ink and/or fountain, thereby revealing the hydrophilic surface of the lithographic substrate which defines the non-printing areas of the master, whereas the non-exposed areas are not removable with ink and/or fountain and define the hydrophobic, printing areas of the master. In a more preferred embodiment, the material is negative-working, i.e. the unexposed areas of the image-recording layer are removable with ink and/or fountain, thereby revealing the hydrophilic surface of the lithographic substrate which defines the non-printing areas of the master, whereas the exposed areas are not removable with ink and/or fountain and define the hydrophobic, printing areas of the master. The term removable indicates that the image-recording layer can be removed by dissolution of the layer in the ink and/or fountain or by the formation of a dispersion or emulsion in the ink and/or fountain.

Two highly preferred embodiments of such a negative-working image-recording layer that is suitable for 'hidden processing' with ink and/or fountain will now be discussed.

In a first highly preferred embodiment, the working mechanism of the imaging layer relies on the heat-induced coalescence of hydrophobic thermoplastic polymer particles, preferably dispersed in a hydrophilic binder, as described in e.g. EP 770 494; EP 770 495; EP 770 497; EP 773 112; EP 774 364; and EP 849 090. The coalesced polymer particles define a hydrophobic, printing area which is not readily removable with the ink and/or fountain whereas the unexposed layer defines a non-printing area which is readily removable with ink and/or fountain. The thermal coalescence can be induced by direct exposure to heat, e.g. by means of a thermal head, or by the light absorption of one or more compounds that are capable of converting light, more preferably infrared light, into heat. Particularly useful light-to-heat converting compounds are for example dyes, pigments, carbon black, metal carbides, borides, nitrides, carbonitrides, bronze-structured oxides, and conductive polymer dispersions such as polypyrrole, polyaniline or polythiophene-based conductive polymer dispersions. Infrared dyes and carbon black are highly preferred.

The hydrophobic thermoplastic polymer particles preferably have a coagulation temperature above 35°C and more preferably above 50°C. Coagulation may result from softening or melting of the thermoplastic polymer particles under the influence of heat. There is no specific upper limit to the coagulation temperature of the thermoplastic hydrophobic polymer particles, however the temperature should be sufficiently below the decomposition of the polymer particles. Preferably the coagulation temperature is at least 10°C below the temperature at which the decomposition of the polymer particles occurs. Specific examples of hydrophobic polymer particles are e.g. polyethylene, polyvinyl chloride, polymethyl (meth)acrylate, polyethyl (meth)acrylate, polyvinylidene chloride, polyacrylonitrile, polyvinyl carbazole, polystyrene or copolymers thereof. Most preferably used is polystyrene. The weight average molecular weight of the polymers may range from 5,000 to 1,000,000g/mol. The hydrophobic particles may have a particle size from 0.01 µm to 50 µm, more preferably between 0.05 µm and 10 µm and most preferably between 0.05 µm and 2 µm. The amount of hydrophobic thermoplastic polymer particles contained in the image forming layer is preferably between 20% by weight and 65% by weight and more preferably between 25% by weight and 55% by weight and most preferably between 30% by weight and 45% by weight.

Suitable hydrophilic binders are for example synthetic homo- or copolymers such as a polyvinylalcohol, a poly(meth)acrylic acid, a poly(meth)acrylamide, a polyhydroxyethyl(meth)acrylate, a polyvinylmethylether or natural binders such as gelatin, a polysacharide such as e.g. dextran, pullulan, cellulose, arabic gum, alginic acid.

In the second highly preferred embodiment, the imaging layer comprises an aryldiazosulfonate homo- or copolymer which is hydrophilic and soluble in the ink and/or fountain before exposure and rendered hydrophobic and less soluble after such exposure. The exposure can be done by the same means as discussed above in connection with thermal coalescence of polymer particles. Alternatively, the aryldiazosulfonate polymer can also be converted by exposure to UV light, e.g. by a UV laser or a UV lamp.

Preferred examples of such aryldiazosulfonate polymers are the compounds which can be prepared by homo- or copolymerization of aryldiazosulfonate monomers with other aryldiazosulfonate monomers and/or with vinyl monomers such as (meth)acrylic acid or esters thereof, (meth)acrylamide, acrylonitrile, vinylacetate, vinylchloride, vinylidene chloride, styrene, α-methyl styrene etc. Suitable aryldiazosulfonate polymers for use in the present invention have the following formula: 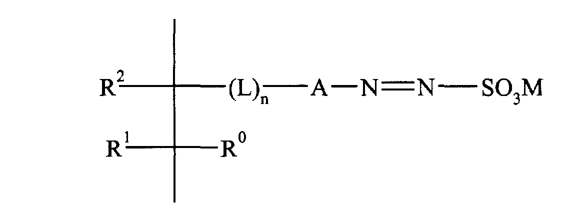 wherein R^{0,1,2} each independently represent hydrogen, an alkyl group, a nitrile or a halogen, e.g. Cl, L represents a divalent linking group, n represents 0 or 1, A represents an aryl group and M represents a cation. L preferably represents divalent linking group selected from the group consisting of -Xₜ-CONR³-, -Xₜ-COO-, -X- and -Xₜ-CO-, wherein t represents 0 or 1, R³ represents hydrogen, an alkyl group or an aryl group, X represents an alkylene group, an arylene group, an alkylenoxy group, an arylenoxy group, an alkylenethio group, an arylenethio group, an alkylenamino group, an arylenamino group, oxygen, sulfur or an aminogroup. A preferably represents an unsubstituted aryl group, e.g. an unsubstituted phenyl group or an aryl group, e.g. phenyl, substituted with one or more alkyl group, aryl group, alkoxy group, aryloxy group or amino group. M preferably represents a cation such as NH₄⁺ or a metal ion such as a cation of Al, Cu, Zn, an alkaline earth metal or alkali metal.

Suitable aryldiazosulfonate monomers for preparing the above polymers are disclosed in EP-A 339393, EP-A 507008 and EP-A 771645.

### The exposure step

The printing plate precursor can be image-wise exposed by an off-press exposure apparatus and subsequently mounted on a print cylinder of a printing press. More preferably, the printing plate precursor is exposed on-press by an integrated exposure apparatus while being mounted on a press cylinder. The imaging materials used in the present invention are exposed to heat or to light, e.g. by means of a thermal head, LEDs or a laser head. Preferably, one or more lasers such as He/Ne or Ar lasers are used. Most preferably, the light used for the exposure is not visible light so that daylight-stable materials can be used, e.g. UV (laser) light or a laser emitting near infrared light having a wavelength in the range from about 700 to about 1500 nm is used, e.g. a semiconductor laser diode, a Nd:YAG or a Nd:YLF laser. The required laser power depends on the sensitivity of the image-recording layer, the pixel dwell time of the laser beam, which is determined by the spot diameter (typical value of modern plate-setters at 1/e² of maximum intensity : 10-25 µm), the scan speed and the resolution of the exposure apparatus (i.e. the number of addressable pixels per unit of linear distance, often expressed in dots per inch or dpi; typical value : 1000-4000 dpi).

### The optional processing step

As mentioned above, the need for a processing step depends on the choice of the imaging material. Materials which require processing are preferably used in an off-press exposure apparatus, which may be mechanically coupled to or may comprise a processing apparatus.

More preferably, processless materials are used or materials which can be processed on-press by supplying ink and/or fountain to the image-recording layer. The materials which rely on heat-induced coalescence of hydrophobic thermoplastic polymer particles in a hydrophilic binder, or the arydiazosulfonate polymers, discussed above, are preferred examples of imaging materials which allow such 'hidden on-press processing' by ink and/or fountain. In a preferred method, such materials are mounted on the press and, then, while the print cylinder with the imaging element mounted thereon rotates, the dampener rollers that supply dampening liquid are dropped on the imaging element and subsequent thereto the ink rollers are dropped. Generally, after about 10 revolutions of the print cylinder the first clear and useful prints are obtained. According to an alternative method for processing such materials, the ink rollers and dampener rollers may be dropped simultaneously or the ink rollers may be dropped first. Suitable dampening liquids that can be used in connection with such materials are aqueous liquids generally having an acidic pH and comprising an alcohol such as isopropanol.

Instead of ink and fountain, also single-fluid ink can be used. The 'hidden processing' of the imaging material with single-fluid ink can be preceded by an optional step wherein the image-recording layer is first moistened or allowed to swell by the supply of water or an aqueous liquid, without thereby substantially removing the image-recording layer.

Preferably the same ink is used in the processing step and the subsequent printing step. In that embodiment, the steps of 'hidden processing' and printing are part of the same operation : after exposure, the printing process is started by feeding ink and/or fountain to the material; after the first few revolutions of the print cylinder, the imaging layer is completely processed and subsequently, high-quality printed copies are obtained throughout the press run.

Besides the optional processing step which may be necessary to obtain a lithographic image, other post-imaging treatments can be useful, such as a fixing step, a post-bake step, a gumming step, a rinsing step, etc.

In combination with other materials, e.g. ablative imaging materials, it may be advantageous to wipe the image-recording layer of an image-wise exposed imaging material (to remove ablation debris) with e.g. a cotton pad or sponge soaked with water before or after mounting the imaging material on the press or at least before the printing press starts running.

### The cleaning step

In a preferred printing method, the ink-accepting areas of the used printing master are removed from the substrate by cleaning means. The cleaning step is preferably characterized by a low risk of deteriorating the lithographic surface of the substrate, yet also by an effective removal of the ink-accepting areas, which may be a difficult compromise to achieve. The cleaning means may be means for treating the surface of the substrate scan-wise, e.g. a laser head for cleaning by ablation or a cleaning head comprising a nozzle for jetting or spraying a cleaning liquid on the substrate. Alternatively, the cleaning can be done in dip-tanks holding a cleaning liquid wherein the printing master is dipped. The above means for cleaning can be combined with means for ultrasound treatment or mechanical cleaning means. Suitable mechanical means for cleaning the substrate are e.g. means for scraping the substrate, means for rubbing the substrate, e.g. a rotating brush, a cloth or another absorbing medium, which may be moistened with a cleaning liquid, or means for jetting or spraying water or a volatile medium such as air, a solvent or dry ice pellets.

A preferred cleaning liquid should be sufficiently effective, e.g. should be able to avoid the appearance of any ghost image after several cycles (preferably >10, most preferably >20) of coating, exposing, printing and cleaning. Other preferred characteristics of the cleaning liquid are a low volatile organic content to avoid environmental contamination and inertness towards the hardware of the plate-making apparatus, e.g. it is preferably a liquid which does not affect rubber, seals or other materials used in the plate-making apparatus. Suitable cleaning liquid compositions which comply with the above requirements have been disclosed in EP-As no. 00200176, 00200177 and 00200178, all filed on 18-01-2000.

The cleaning liquid can be supplied by coating, spraying or jetting. Preferably, the same print head is used for the coating and the cleaning step. The cleaning is preferably followed by a rinsing step. e.g. by spraying or jetting water or an aqueous solution onto the substrate. The plate can then be dried by e.g. hot air, vacuum extraction or an absorbing medium such as a cloth.

### EXAMPLES

### Preparation of a coating solution

A 2.61 wt.% aqueous solution is prepared by mixing a polystyrene latex, the infrared dye IR-1 (formula below) and Glascol E15 (a polyacrylic acid commercially available from N.V. Allied Colloids Belgium) in a weight ratio of 75:10:15. Additionally, a surfactant is added to reduce the surface tension of the solution to 27 mN/m.

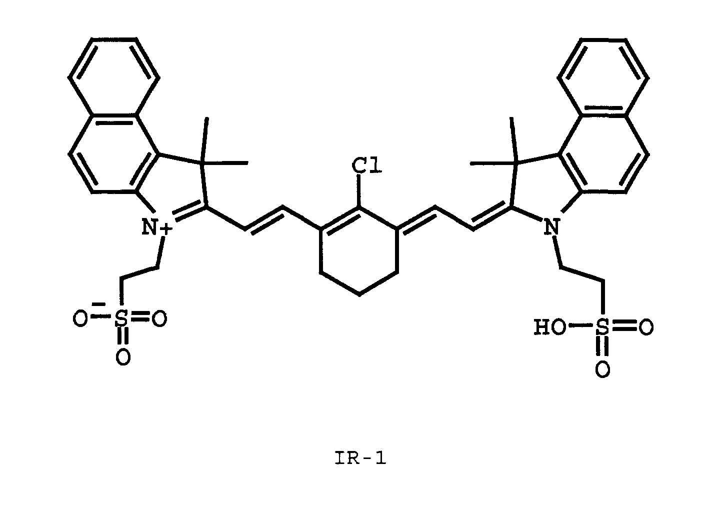

### Preparation of a lithographic substrate

A 0.20 mm thick aluminium foil was degreased by immersing the foil in an aqueous solution containing 5 g/l of sodium hydroxide at 50°C and rinsed with demineralised water. The foil was then electrochemically grained using an alternating current in an aqueous solution containing 4 g/l of hydrochloric acid, 4 g/l of hydroboric acid and 5 g/l of aluminium ions at a temperature of 35°C and a current density of 1200 A/m² to form a surface topography with an average centre-line roughness Ra of 0.5 µm.

After rinsing with demineralised water the aluminium foil was etched with an aqueous solution containing 300 g/l of sulphuric acid at 60°C for 180 seconds and rinsed with demineralised water at 25°C for 30 seconds.

The foil was subsequently subjected to anodic oxidation in an aqueous solution containing 200 g/l of sulphuric acid at a temperature of 45°C, a voltage of about 10 V and a current density of 150 A/m² for about 300 seconds to form an anodic oxidation film of 3.00 g/m² of Al₂O₃, then washed with demineralised water, post treated with a solution containing polyvinylphosphonic acid and subsequently with a solution containing aluminium trichloride, rinsed with demineralised water at 20°C during 120 seconds and dried.

### Coating step

The above lithographic substrate was mounted on a cylinder. In Comparative Example 1, the coating solution described above was sprayed on the substrate with an air-assisted spray nozzle of the type SUV76, commercially available at Spraying Systems Belgium, Brussels. The spray nozzle was mounted at a distance of 40 mm between the nozzle and the substrate. During the spraying step, the cylinder was rotating at a line speed of 164 m/min and the spray nozzle was moving in the axial direction of the cylinder at a speed of 1.5 m/min. The flow rate of the spray solution was set to 7 ml/min. During the spray process an air pressure of 90 psi was used on the spray head. The coating was dried at an air temperature of 70°C. An image recording layer having a dry thickness of 0.83 µm (measured by means of reflectance densitometry) was obtained after six passes of the spray nozzle.

In Example 2, the same coating solution was applied on the substrate using the same apparatus as described above with the proviso that the spray nozzle was replaced by a valve-jet print head of the type JET-A-MARK 5000, commercially available from Matthews Swedot in Göteborg, Sweden. The setttings were adjusted so as to obtain a comparable coating thickness as in Example 1 in a single pass of the valve-jet print head.

In both Example 1 and 2, the coating was applied on a rectangular section of the substrate, said section having a size of about 50x40 cm. The coating head (respectively spray nozzle and valve-jet print head) was driven so as to obtain a uniform coating inside said rectangle and no coating outside said rectangle. The coating yield was calculated as the ratio of the weight of the rectangular layer over the dry weight of the coating solution that had been supplied to the coating head. The coating yield of Example 1 and 2 thus obtained was 70% and 100% respectively.

As a second test, paper strips were attached onto the lithographic substrate just above and below the rectangular section and, after the coating, the colour of these paper strips was evaluated. The paper strips used in Example 2 were not coloured whereas the paper strips of Example 1 showed a substantial colour. These results indicate that the valve-jet technique used in Example 2 provides an excellent coating yield and no waste.

## Claims

1. A method for making a printing plate precursor by applying a coating solution onto a substrate by means of a valve-jet print head, thereby obtaining a heat- or light-sensitive image-recording layer.

2. A method according to claim 1 wherein pressurised gas is used for driving the coating solution out of the valve-jet print head.

3. A method according to any of the preceding claims wherein the valve-jet print head is mounted on a shuttle that is movable over the substrate.

4. A method according to any of the preceding claims wherein the image-recording layer is applied onto the substrate by means of a plurality of valve-jet print heads.

5. A direct-to-plate lithographic printing method comprising the steps of:
- making a printing plate precursor by a method as defined in any of claims 1 to 4;
- image-wise exposing the image-recording layer to heat or light and optionally processing the image-recording layer, thereby obtaining a printing master;
- applying ink and/or fountain solution to the printing master;
- removing ink accepting areas from the lithographic substrate by supplying a cleaning liquid thereto.

6. A method according to claim 5 wherein all the steps are carried out while the lithographic substrate is mounted in a printing press.

7. A method according to claim 6 wherein the substrate is a plate cylinder of a printing press or a plate or a sleeve mounted on a plate cylinder of a printing press.

8. A method according to any of claims 5 to 7 wherein the image-recording layer is removable with the ink and/or fountain or is rendered removable with the ink and/or fountain upon exposure to heat or light.

9. A method according to claim 8 wherein the ink is single-fluid ink.

10. A method according to any of the preceding claims wherein the image-recording layer comprises hydrophobic thermoplastic polymer particles and a radiation-to-heat converting compound.

## Patentansprüche

1. Ein Verfahren zur Herstellung einer Druckplattenvorstufe durch Auftrag einer Gießlösung auf ein Substrat mittels eines Valve Jet-Druckkopfes, wobei eine wärmeempfindliche oder lichtempfindliche Bildaufzeichnungsschicht erhalten wird.

2. Verfahren nach Anspruch 1, **dadurch gekennzeichnet, daß** die Gießlösung mittels Druckgas ais dem Valve Jet-Druckkopf ausgestoßen wird.

3. Verfahren nach einem der vorstehenden Ansprüche, **dadurch gekennzeichnet, daß** der Valve Jet-Druckkopf auf einem hin und her über das Substrat bewegbaren Schlitten angeordnet ist.

4. Verfahren nach einem der vorstehenden Ansprüche, **dadurch gekennzeichnet, daß** die Bildaufzeichnungsschicht mittels einer Vielzahl von Valve Jet-Druckköpfen auf das Substrat angebracht wird.

5. Ein durch die nachstehenden Schritte gekennzeichnetes lithografisches Direct-to-Plate-Druckverfahren :
- Herstellung einer Druckplattenvorstufe nach einem wie in einem der Ansprüche 1 bis 4 definierten Verfahren,
- bildmäßige Belichtung oder Beaufschlagung mit Wärme der Bildaufzeichnungsschicht und gegebenenfalls Entwicklung der Bildaufzeichnungsschicht, wobei ein Druckmaster erhalten wird,
- Auftrag von Druckfarbe und/oder Feuchtwasser auf den Druckmaster,
- Entfernung von farbanziehenden Bereichen vom lithografischen Substrat durch Auftrag einer Reinigungsflüssigkeit auf das Substrat.

6. Verfahren nach Anspruch 5, **dadurch gekennzeichnet, daß** all die Schritte mit dem in eine Druckpresse eingespannten lithografischen Substrat durchgeführt werden.

7. Verfahren nach Anspruch 6, **dadurch gekennzeichnet, daß** das Substrat entweder eine Plattentrommel einer Druckpresse oder eine auf eine Plattentrommel einer Druckpresse aufgespannte Platte oder hülsenförmige Platte ist.

8. Verfahren nach einem der Ansprüche 5 bis 7, **dadurch gekennzeichnet, daß** die Bildaufzeichnungsschicht durch die Druckfarbe und/oder das Feuchtwasser entfernt werden kann oder durch Belichtung oder Beaufschlagung mit Wärme entfernbar durch die Druckfarbe und/oder das Feuchtwasser gemacht werden kann.

9. Verfahren nach Anspruch 8, **dadurch gekennzeichnet, daß** die Druckfarbe eine Single-Fluid-Druckfarbe ist.

10. Verfahren nach einem der vorstehenden Ansprüche, **dadurch gekennzeichnet, daß** die Bildaufzeichnungsschicht hydrophobe thermoplastische polymere Teilchen und eine Strahlung in Wärme umwandelnde Verbindung enthält.

## Revendications

1. Procédé pour préparer un précurseur de cliché d'impression en appliquant une solution d'enduction sur un substrat à l'aide d'une tête d'impression du type à jet-soupape pour ainsi obtenir une couche d'enregistrement d'image thermosensible ou photosensible.

2. Procédé selon la revendication 1, dans lequel on utilise du gaz sous pression pour entraîner la solution d'enduction à l'extérieur de la tête d'impression du type à jet-soupape.

3. Procédé selon l'une quelconque des revendications précédentes, dans lequel la tête d'impression du type à jet-soupape est montée sur une navette qui est mobile par-dessus le substrat.

4. Procédé selon une quelconque des revendications précédentes, dans lequel la couche d'enregistrement d'image est appliquée sur le substrat à l'aide de plusieurs têtes d'impression du type à jet-soupape.

5. Procédé d'impression lithographique faisant appel à une imageuse de plaques flexographiques, comprenant les étapes consistant à :
- préparer un précurseur de cliché d'impression via un procédé tel que défini dans l'une des revendications 1 à 4 ;
- exposer en forme d'image la couche d'enregistrement d'image à de la chaleur ou à de la lumière et traiter le cas échéant la couche d'enregistrement d'image pour ainsi obtenir une matrice d'impression ;
- appliquer de l'encre et/ou une solution de mouillage sur la matrice d'impression ;
- éliminer les zones acceptant l'encre du substrat lithographique en alimentant un liquide de nettoyage sur ce dernier.

6. Procédé selon la revendication 5, dans lequel on effectue toues les étapes tandis que le substrat lithographique est monté sur une presse d'impression.

7. Procédé selon la revendication 6, dans lequel le substrat est un cylindre porte-plaques d'une presse impression ou un cliché ou encore un manchon monté sur un cylindre porte-plaques d'une presse d'impression.

8. Procédé selon l'une quelconque des revendications 5 à 7 dans lequel la couche d'enregistrement d'image peut être éliminée avec l'encre et/ou la solution de mouillage ou est rendu apte à être éliminée avec l'encre et/ou la solution de mouillage lors d'une exposition à de la chaleur ou à de la lumière.

9. Procédé selon la revendication 8, dans lequel l'encre est une encre de type simple fluide.

10. Procédé selon l'une quelconque des revendications précédentes, dans lequel la couche d'enregistrement d'image comprend des particules polymères thermoplastiques hydrophobes et un composé transformant le rayonnement en chaleur.
